(19) Europäisches Patentamt
European Patent Office
Office européen des brevets

(11) **EP 4 297 425 B1**

(12) **FASCICULE DE BREVET EUROPEEN**

(45) Date de publication et mention
de la délivrance du brevet:
**30.04.2025 Bulletin 2025/18**

(21) Numéro de dépôt: **23181139.9**

(22) Date de dépôt: **23.06.2023**

(51) Classification Internationale des Brevets (IPC):
*H04R 1/02* $^{(2006.01)}$     *H03G 3/30* $^{(2006.01)}$
*H03G 1/00* $^{(2006.01)}$     *H04R 3/04* $^{(2006.01)}$
*H04R 5/04* $^{(2006.01)}$

(52) Classification Coopérative des Brevets (CPC):
**H04R 1/028; H03G 3/3005;** H04R 3/04; H04R 5/04;
H04R 2420/01; H04R 2430/01

(54) **PARAMETRES AUDIO FONCTION DE LA LUMIERE**

LICHTABHÄNGIGE AUDIOPARAMETER

LIGHT-DEPENDENT AUDIO PARAMETERS

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **23.06.2022 FR 2206276**

(43) Date de publication de la demande:
**27.12.2023 Bulletin 2023/52**

(73) Titulaire: **Sagemcom Broadband SAS
92270 Bois-Colombes (FR)**

(72) Inventeurs:
• **BERGER, Jérôme
92500 RUEIL MALMAISON (FR)**
• **SCHOTT, Vincent
92500 RUEIL MALMAISON (FR)**

(74) Mandataire: **Cabinet Boettcher et al
5, rue de Vienne
75008 Paris (FR)**

(56) Documents cités:
**US-A1- 2016 057 555    US-A1- 2016 149 547
US-A1- 2016 162 255    US-A1- 2020 380 979**

**Description**

L'invention concerne le domaine des équipements électriques de restitution audio.

ARRIERE PLAN DE L'INVENTION

De nombreux équipements électriques récents, de type « multimédia » ou « grand public », intègrent un ou plusieurs haut-parleurs et sont donc capables de restituer des signaux audio (de la musique par exemple).

Parmi ces équipements de restitution audio, on trouve bien sûr des enceintes, et notamment des enceintes connectées. On trouve aussi des boîtiers décodeurs (ou STB, pour *Set-Top Box*) améliorés. On trouve en outre des ordinateurs, des smartphones, des consoles de jeux, etc.

Pour améliorer l'expérience auditive de l'utilisateur, il est souvent possible de régler des paramètres audio qui sont appliqués sur le signal audio juste avant sa restitution par le ou les haut-parleurs. Les paramètres audio permettent par exemple de régler une courbe d'égalisation qui spécifie un gain à appliquer en fonction de la fréquence, afin de faire ressortir ou d'atténuer les basses, les mediums ou les aigus. Les paramètres audio peuvent aussi permettre de régler des filtres, tels que par exemple un filtre de réverbération ou un filtre atténuateur de bruit de fond.

Les paramètres audio sont généralement ajustables par l'utilisateur soit en agissant directement sur l'équipement de restitution audio (via un bouton, un variateur, etc.), soit en interagissant avec un menu de configuration proposé par l'équipement de restitution audio lui-même, ou bien via un autre équipement relié audit équipement de restitution audio. La restitution sonore de certaines enceintes peut ainsi être configurée via une application dédiée téléchargée dans un smartphone.

L'utilisateur doit donc modifier lui-même « manuellement » les différents paramètres audio, ce qui peut s'avérer compliqué, en particulier si l'utilisateur n'a pas l'habitude de manipuler de tels équipements. De plus, l'utilisateur ne choisit pas nécessairement les paramètres audio les plus adaptés, et donc il est très fréquent qu'un utilisateur n'exploite jamais pleinement les capacités de restitution sonore de son équipement.

Le document US 2016/162255 A1 décrit décrit un équipement de restitution audio comprenant un capteur de luminosité. Le document US 2016/057555 A1 décrit un équipement de restitution audio comprenant une caméra interne utilisée pour détecter la présence d'un utilisateur.

OBJET DE L'INVENTION

L'invention a pour objet d'améliorer l'expérience auditive de l'utilisateur d'un équipement de restitution audio.

RESUME DE L'INVENTION

En vue de la réalisation de ce but, on propose un équipement de restitution selon la revendication 1.

L'unité de traitement sélectionne donc, en fonction de la lumière éclairant l'environnement de l'équipement, des valeurs courantes des paramètres audio qui sont appliquées sur le signal audio restitué par l'équipement. La sélection est entièrement automatique et ne nécessite pas de manipulation de l'utilisateur. L'utilisateur bénéficie ainsi d'une restitution sonore optimisée en fonction de l'éclairage et donc, notamment, en fonction du moment de la journée.

On propose de plus un équipement de restitution audio tel que précédemment décrit, dans lequel les valeurs courantes des paramètres audio sont sélectionnées parmi des premières valeurs des paramètres audio et des deuxièmes valeurs des paramètres audio, l'unité de traitement étant agencée pour comparer le paramètre lumineux avec au moins un seuil prédéterminé, et pour sélectionner les premières valeurs des paramètres audio ou les deuxièmes valeurs des paramètres audio en fonction de ladite comparaison.

On propose de plus un équipement de restitution audio tel que précédemment décrit, l'unité de traitement étant agencée pour

- comparer le paramètre lumineux avec un seuil prédéterminé bas et avec un seuil prédéterminé haut ;
- si ledit paramètre lumineux est inférieur au seuil prédéterminé bas, sélectionner et appliquer sur le signal audio primaire les premières valeurs des paramètres audio ;
- si ledit paramètre lumineux est supérieur au seuil prédéterminé haut, sélectionner et appliquer sur le signal audio primaire les deuxièmes valeurs des paramètres audio.

On propose de plus un équipement de restitution audio tel que précédemment décrit, dans lequel l'unité de traitement est agencée pour, si ledit paramètre lumineux est compris entre le seuil prédéterminé bas et le seuil prédéterminé haut, continuer à faire appliquer sur le signal audio primaire les valeurs courantes des paramètres audio préalablement sélectionnées.

On propose de plus un équipement de restitution audio tel que précédemment décrit, dans lequel l'unité de traitement est agencée pour, si ledit paramètre lumineux est compris entre le seuil prédéterminé bas et le seuil prédéterminé haut, faire produire le signal audio secondaire en utilisant un coefficient de pondération, les premières valeurs des paramètres audio et les deuxièmes valeurs des paramètres audio, le coefficient de pondération étant calculé à partir du seuil prédéterminé bas, du seuil prédéterminé haut et dudit paramètre lumineux.

On propose de plus un équipement de restitution audio tel que précédemment décrit, l'équipement de restitution audio comprenant ou étant relié à une caméra, un module d'exposition automatique étant intégré dans ou relié à ladite caméra, le au moins un paramètre lumineux comprenant une luminosité, l'unité de traitement étant agencée pour estimer la luminosité à partir de paramètres d'exposition sélectionnés par le module d'exposition automatique.

On propose de plus un équipement de restitution audio tel que précédemment décrit, l'équipement de restitution audio comprenant ou étant relié à une caméra, le au moins un paramètre lumineux comprenant une température de couleur, l'unité de traitement étant agencée pour :

- acquérir une image produite par la caméra ;
- estimer la température de couleur à partir de ladite image.

On propose de plus un équipement de restitution audio tel que précédemment décrit, comprenant l'étape de calculer une couleur moyenne de pixels de l'image, et d'estimer la température de couleur à partir de la couleur moyenne.

On propose de plus un équipement de restitution audio tel que précédemment décrit, l'unité de traitement étant agencée pour, lorsque de nouvelles valeurs courantes des paramètres audio ont été sélectionnées pour remplacer de précédentes valeurs courantes des paramètres audio :

- initialiser un coefficient de combinaison au début d'une période de transition de durée prédéterminée, et faire varier progressivement le coefficient de combinaison pendant la période de transition ;
- au cours de la période de transition, produire le signal audio secondaire en utilisant le coefficient de combinaison, les précédentes valeurs courantes des paramètres audio et les nouvelles valeurs courantes des paramètres audio ;
- suite à la période de transition, produire le signal audio secondaire en utilisant les nouvelles valeurs courantes des paramètres audio.

On propose de plus un équipement de restitution audio tel que précédemment décrit, l'unité de traitement étant agencée pour, lorsque de nouvelles valeurs courantes des paramètres audio ont été sélectionnées pour remplacer de précédentes valeurs courantes des paramètres audio, attendre la survenue d'une période de silence dans le signal audio primaire, et effectuer le remplacement au cours de ladite période de silence.

On propose de plus un équipement de restitution audio tel que précédemment décrit, l'unité de traitement étant agencée pour, lorsque de nouvelles valeurs courantes des paramètres audio ont été sélectionnées pour remplacer de précédentes valeurs courantes des paramètres audio, attendre une réception d'un ordre de changement provenant d'un utilisateur et ayant pour but d'appliquer un changement sur le signal audio primaire, puis effectuer le remplacement en même temps que le changement est réalisé.

On propose de plus un équipement de restitution audio tel que précédemment décrit, l'unité de traitement étant agencée pour recevoir des métadonnées identifiant un programme en cours de diffusion incluant le signal audio primaire, et, lorsque de nouvelles valeurs courantes des paramètres audio ont été sélectionnées pour remplacer de précédentes valeurs courantes des paramètres audio, attendre que les métadonnées indiquent un changement du programme en cours de diffusion, puis effectuer le remplacement en même temps que le changement est réalisé.

On propose de plus un équipement de restitution audio tel que précédemment décrit, dans lequel les paramètres audio comprennent :

- des paramètres d'égalisation, comprenant des gains ou des listes de gains pour différentes bandes de fréquences, et/ou
- des paramètres d'activation d'un ou de plusieurs filtres, et/ou
- des paramètres de filtrage définissant, pour chaque filtre, une réponse dudit filtre.

On propose de plus un équipement de restitution audio tel que précédemment décrit, dans lequel le ou les filtres comprennent un filtre correcteur physiologique et/ou un filtre compresseur et/ou un filtre d'amélioration de l'intelligibilité de la voix et/ou un filtre de réverbération et/ou un filtre atténuateur de bruit de fond.

On propose de plus un équipement de restitution audio tel que précédemment décrit, l'équipement de restitution audio étant un boîtier décodeur.

On propose de plus un procédé de restitution audio selon la revendication 17.

On propose de plus un programme d'ordinateur comprenant des instructions qui conduisent l'unité de traitement de l'équipement de restitution audio tel que précédemment décrit à exécuter les étapes du procédé de restitution audio tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit de modes de mise en œuvre particuliers non limitatifs de l'invention.

BREVE DESCRIPTION DES DESSINS

Il sera fait référence aux dessins annexés parmi lesquels :

[Fig. 1] la figure 1 représente une source d'un flux audio-vidéo, un boîtier décodeur et un téléviseur ;
[Fig. 2] la figure 2 représente des étapes d'un procédé de restitution audio selon un mode de réalisation ;

[Fig. 3] la figure 3 représente des étapes dudit procédé selon un autre mode de réalisation ;

[Fig. 4] la figure 4 représente des étapes d'une méthode, selon un mode de réalisation, permettant de produire un signal audio secondaire en combinant deux jeux de valeurs de paramètres ;

[Fig. 5] la figure 5 représente des étapes de ladite méthode, selon un autre mode de réalisation ;

[Fig. 6] la figure 6 est un graphique définissant, en fonction de la température de couleur et de la luminosité, des zones dans lesquelles différents profils audio sont utilisés.

## DESCRIPTION DETAILLEE DE L'INVENTION

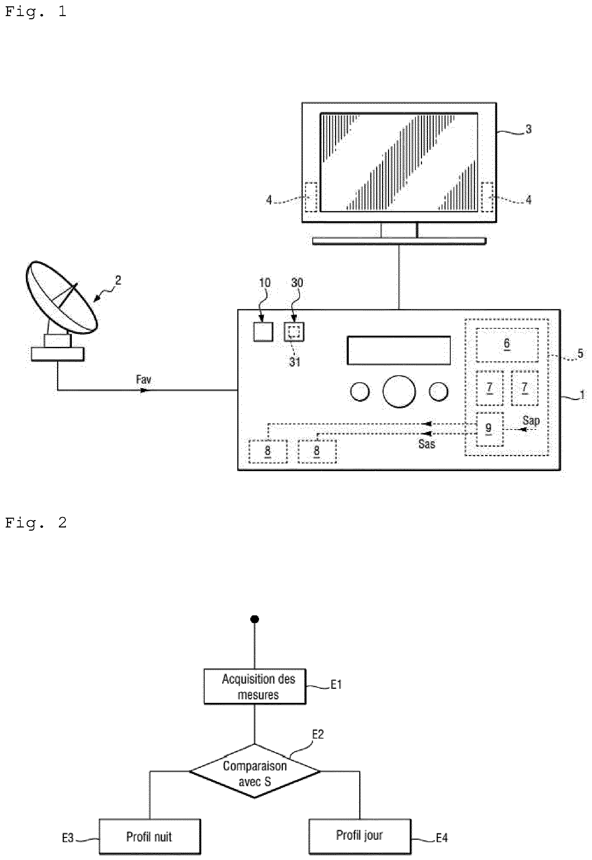

En référence à la figure 1, l'équipement de restitution audio selon un mode de réalisation particulier est un boîtier décodeur audio-vidéo 1, qui permet de transmettre un flux audio-vidéo Fav, produit par une source 2, à un ou des équipements externes qui restituent le flux audio-vidéo Fav.

La source 2 est par exemple un réseau de diffusion. Le réseau de diffusion peut être un réseau de télévision par satellite, une connexion Internet, un réseau de télévision numérique terrestre (TNT), un réseau de télévision par câble, etc. La source 2 peut aussi être un autre équipement connecté au boîtier décodeur 1, et par exemple un lecteur de CD, de DVD ou de BlueRay. La source 2 peut aussi être un support de stockage tel qu'une clef USB ou une carte mémoire connectée au boîtier décodeur 1.

Les équipements externes comprennent ici un téléviseur 3 qui intègre un ou des haut-parleurs externes 4.

Le boîtier décodeur 1 comporte tout d'abord une unité de traitement 5.

L'unité de traitement 5 comprend un ou plusieurs composants de traitement 6, et par exemple un processeur ou un microprocesseur quelconque(s), généraliste(s) ou spécialisé(s) (par exemple un DSP, pour *Digital Signal Processor*, ou un GPU, pour *Graphics Processing Unit*), un microcontrôleur, ou bien un circuit logique programmable tel qu'un FPGA (pour *Field Programmable Gate Arrays*) ou un ASIC (pour *Application Specific Integrated Circuit*).

L'unité de traitement 5 comprend aussi des mémoires 7. Au moins l'une de ces mémoires 7 forme un support d'enregistrement lisible par ordinateur, sur lequel est enregistré au moins un programme d'ordinateur comprenant des instructions qui conduisent l'unité de traitement 5 à exécuter au moins certaines des étapes du procédé de restitution audio qui va être décrit. L'une de ces mémoires 7 peut être intégrée dans l'un des composants de traitement 6.

Le boîtier décodeur 1 comprend de plus un ou des haut-parleurs internes 8, et un module audio 9 qui est ici intégré dans l'unité de traitement 5 et qui est relié aux haut-parleurs internes 8. Le boîtier décodeur 1 comprend aussi des moyens de connexion aux haut-parleurs externes 4 du téléviseur 3. On note ici que l'invention peut être mise en œuvre dans un équipement électrique qui intègre au moins un haut-parleur interne et/ou qui comprend des moyens de connexion avec au moins un haut-parleur externe.

Le boîtier décodeur 1 est ainsi capable de restituer des signaux audio via ses propres haut-parleurs internes 8, ou bien via les haut-parleurs externes 4 du téléviseur 3.

Le module audio 9, piloté par l'unité de traitement 5, applique des traitements sur un signal audio primaire Sap, compris par exemple dans le flux audio-vidéo, pour produire un signal audio secondaire Sas. Le signal audio secondaire Sas est alors restitué via les haut-parleurs internes 8 et/ou les haut-parleurs externes 4.

Les traitements consistent notamment à appliquer sur le signal audio primaire Sap un profil audio particulier parmi différents profils audio.

Par « profil audio », on entend des valeurs particulières de paramètres audio affectant la restitution du son.

Les paramètres audio comprennent par exemple :

- des paramètres d'égalisation, comprenant des gains ou des listes de gains pour différentes bandes de fréquences, et/ou
- des paramètres d'activation d'un ou de plusieurs filtres, et/ou
- des paramètres de filtrage définissant, pour chaque filtre, une réponse dudit filtre.

Les paramètres d'égalisation définissent une courbe d'égalisation qui spécifie un gain à appliquer en fonction de la fréquence, afin de faire ressortir ou d'atténuer les basses, les mediums ou les aigus. Les paramètres d'égalisation comprennent donc des gains ou des listes de gains pour différentes bandes de fréquences. Les bandes de fréquences comprennent par exemple une bande correspondant aux basses fréquences (sons graves, fréquences par exemple comprises entre 20Hz et 500Hz), une bande correspondant aux fréquences medium (fréquences par exemple comprises entre 500Hz et 5kHz), et une bande correspondant aux fréquences élevées (sons aigus, fréquences par exemple supérieures à 2kHz).

Le ou les filtres comprennent par exemple un filtre correcteur physiologique (communément appelé « loudness »).

Le paramètre d'activation du filtre est un signal booléen qui peut prendre une première valeur booléenne qui active le filtre ou une deuxième valeur booléenne qui n'active pas le filtre.

Le ou les filtres comprennent par exemple un filtre compresseur. A nouveau, le paramètre d'activation est un signal booléen. Les paramètres audio peuvent aussi comprendre des paramètres de filtrage comprenant un seuil de déclenchement et un rapport de compression.

Le ou les filtres comprennent par exemple un filtre d'amélioration de l'intelligibilité de la voix. A nouveau, le paramètre d'activation est un signal booléen.

Le ou les filtres comprennent par exemple un filtre de réverbération ou un filtre atténuateur de bruit de fond. A nouveau, le paramètre d'activation est un signal booléen.

Bien sûr, les paramètres audio utilisés peuvent comprendre un ou plusieurs des paramètres qui viennent d'être cités.

Les valeurs courantes possibles des paramètres audio sont stockées dans l'une des mémoires 7 de l'unité de traitement 5.

Ici, et de manière non limitative, les valeurs courantes des paramètres audio peuvent être sélectionnées parmi des premières valeurs des paramètres audio et des deuxièmes valeurs des paramètres audio.

Les premières valeurs des paramètres audio forment un profil « nuit » et les deuxièmes valeurs des paramètres audio forment un profil « jour ».

Le profil « jour » peut par exemple comporter des valeurs de paramètres offrant une qualité d'écoute optimale à volume sonore élevé, tandis que le profil « nuit » peut comporter des valeurs de paramètres offrant une qualité d'écoute optimale à volume plus faible.

Par exemple, le profil nuit est tel que les fréquences basses sont atténuées. En effet, il est connu que les basses portent plus loin et sont donc plus gênantes pour les voisins.

Alternativement, l'utilisation du profil nuit peut permettre de baisser globalement le volume tout en choisissant des valeurs de paramètres d'égalisation telles que les basses et les aigus sont moins atténués que les médiums, ce qui permet de donner à l'auditeur une impression de volume plus élevé qu'il n'est réellement (cet effet était en particulier appelé « *loudness* » sur les vieilles chaînes Hi-Fi) .

Selon un autre exemple, le profil nuit peut activer un effet « compresseur » ou « limiteur » qui diminue le volume des séquences bruyantes tout en préservant le volume des séquences calmes. Ainsi, les séquences les plus bruyantes (telles que les explosions dans un film) sont atténuées, mais les séquences calmes restent audibles.

Le boîtier décodeur 1 intègre de plus au moins un capteur photosensible interne et/ou comprend des moyens de connexion avec au moins un capteur photosensible externe.

Le boîtier décodeur 1 peut donc comporter au moins un capteur photosensible interne 10. Le capteur photosensible 10 est par exemple un capteur de luminosité ou un capteur de température de couleur.

Dans le cas où le boîtier décodeur 1 comporte une caméra 30, le capteur photosensible utilisé peut être un capteur intégré dans la caméra 30 - et par exemple le capteur permettant la capture d'images par ladite caméra 30.

Le boîtier décodeur 1 peut aussi comporter plusieurs capteurs photosensibles interne 10, possiblement de type différent.

Le boîtier décodeur 1 peut aussi être connecté à un capteur photosensible externe, situé dans un équipement distinct du boîtier décodeur 1. Le boîter décodeur 1 peut ainsi par exemple être connecté à une caméra intégrant un capteur photosensible. Dans ce cas, le boîtier décodeur 1 comprend des moyens de connexion au capteur photosensible externe. Dans le cas d'une caméra, il s'agit par exemple d'un lien USB.

La lumière, dans l'environnement du boîtier décodeur 1, peut provenir d'une source de lumière naturelle et/ou artificielle.

On considère tout d'abord que le capteur photosensible 10 utilisé est un capteur de luminosité.

En référence à la figure 2, l'unité de traitement 5 acquiert ou estime, en utilisant au moins une mesure produite par le capteur de luminosité, un paramètre lumineux représentatif de la lumière éclairant l'environnement du boîtier décodeur 1 (c'est-à-dire de la lumière régnant dans la pièce dans laquelle est positionné le boîtier décodeur 1).

Le paramètre lumineux est la luminosité. L'unité de traitement 5 acquiert donc les mesures produites par le capteur de luminosité 10 et estime donc la luminosité comme étant égale auxdites mesures (l'unité de traitement 5 peut éventuellement traiter les mesures et par exemple utiliser une moyenne de plusieurs mesures) : étape E1.

Les mesures de luminosité sont réalisées et acquises en continu ou à intervalles réguliers, par exemple toutes les 10s.

L'unité de traitement 5 sélectionne alors, en fonction de la luminosité, des valeurs courantes des paramètres audio. Ici, les valeurs courantes des paramètres audio sont sélectionnées parmi des premières valeurs des paramètres audio (définissant le profil nuit) et des deuxièmes valeurs des paramètres audio (définissant le profil jour).

Pour cela, l'unité de traitement 5 compare la luminosité avec au moins un seuil prédéterminé, et sélectionne les premières valeurs des paramètres audio ou les deuxièmes valeurs des paramètres audio en fonction de ladite comparaison.

Ici, l'unité de traitement 5 compare la luminosité avec un seuil prédéterminé S, égal par exemple à 200 lux : étape E2.

Si la luminosité est inférieure (ici inférieure ou égale) au seuil prédéterminé S, qui est égal par exemple à 200 lux, l'unité de traitement 5 sélectionne comme valeurs courantes des paramètres audio les premières valeurs des paramètres audio (profil nuit) : étape E3

Si la luminosité est supérieure (ici supérieure strictement) au seuil prédéterminé S, l'unité de traitement 5 sélectionne comme valeurs courantes des paramètres audio les deuxièmes valeurs des paramètres audio (profil jour) : étape E4.

L'unité de traitement 5 fait alors appliquer par le module audio 9 les valeurs courantes des paramètres audio sur le signal audio primaire Sap pour produire un signal audio secondaire Sas, et fait restituer le signal audio secondaire Sas via les haut-parleurs internes 8 ou les haut-parleurs externes 4.

Alternativement, la mesure de luminosité peut être réalisée avec hystérésis.

En effet, la comparaison avec un unique seuil prédéterminé présente l'inconvénient que, si la luminosité réelle est proche dudit seuil, alors la luminosité mesurée risque d'alterner entre une valeur supérieure au seuil et une valeur inférieure au seuil, ce qui peut provoquer un effet désagréable lorsque les paramètres audio alternent entre le profil « jour » et le profil « nuit ».

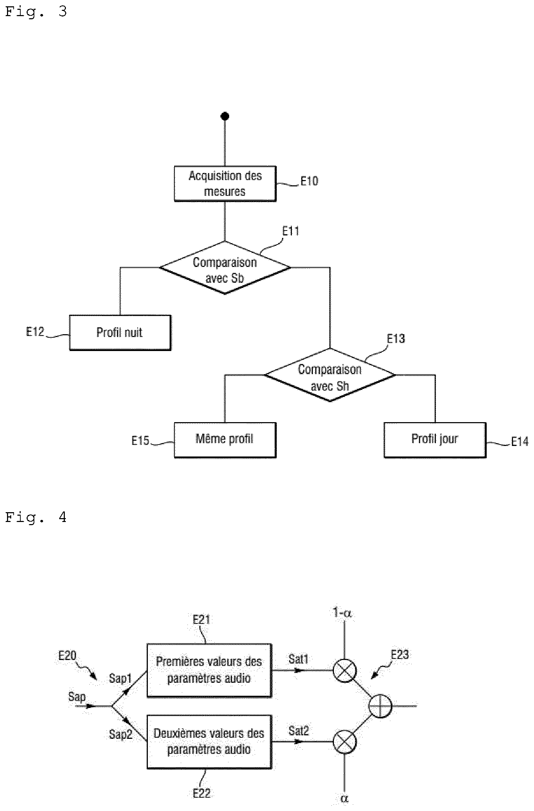

En référence à la figure 3, l'unité de traitement 5 acquiert donc les mesures produites par le capteur de luminosité et estime donc la luminosité comme étant égale auxdites mesures (l'unité de traitement 5 peut éventuellement traiter les mesures et par exemple utiliser une moyenne de plusieurs mesures) : étape E10.

Les mesures de luminosité sont réalisées et acquises en continu ou à intervalles réguliers, par exemple toutes les 10s.

L'unité de traitement 5 compare la luminosité avec un seuil prédéterminé bas Sb : étape E11.

Si la luminosité est inférieure (ici inférieure strictement) au seuil prédéterminé bas Sb, qui est égal par exemple à 100 lux, l'unité de traitement 5 sélectionne comme valeurs courantes des paramètres audio les premières valeurs des paramètres audio (profil nuit) : étape E12.

A l'étape E11, si la luminosité est supérieure ou égale au seuil prédéterminé bas Sb, l'unité de traitement 5 compare la luminosité avec un seuil prédéterminé haut Sh, qui est égal par exemple à 1000 lux : étape E13.

Si la luminosité est supérieure (ici supérieure strictement) au seuil prédéterminé haut Sh, l'unité de traitement 5 sélectionne comme valeurs courantes des paramètres audio les deuxièmes valeurs des paramètres audio (profil jour) : étape E14.

Si la luminosité est comprise entre le seuil prédéterminé bas Sb et le seuil prédéterminé haut Sh, l'unité de traitement 5 continue de faire appliquer sur le signal audio primaire les valeurs courantes des paramètres audio préalablement sélectionnées, c'est-à-dire les premières valeurs des paramètres audio si celles-ci étaient utilisées, ou bien les deuxièmes valeurs des paramètres audio si celles-ci étaient utilisées : étape E15.

Alternativement, à l'étape E15, si la luminosité est comprise entre le seuil prédéterminé bas Sb et le seuil prédéterminé haut Sh, l'unité de traitement 5 combine deux jeux de valeurs de paramètres en fonction d'un coefficient de pondération $\alpha$ compris entre 0 et 1.

Ainsi, si la luminosité $L$ est inférieure (ici inférieure strictement) au seuil prédéterminé bas L⁻ (par exemple égal à 100 lux), le coefficient de pondération $\alpha$ est tel que :

$\alpha=0$ ce qui revient à sélectionner comme valeurs courantes des paramètres audio les premières valeurs des paramètres audio (profil nuit).

Si la luminosité $L$ est supérieure (ici supérieure strictement) au seuil prédéterminé haut L⁺ (par exemple égal à 1000 lux), le coefficient de pondération $\alpha$ est tel que :

$\alpha=1$ ce qui revient à sélectionner comme valeurs courantes des paramètres audio les deuxièmes valeurs des paramètres audio (profil jour).

Par contre, si la luminosité $L$ est comprise entre le seuil prédéterminé bas et le seuil prédéterminé haut, c'est-à-dire si :

$$\mathrm{L}^{-} \leq \mathrm{L} \leq \mathrm{L}^{+}$$

le coefficient de pondération est tel que :

$$\alpha = \frac{L - L^{-}}{L^{+} - L^{-}}$$

Le coefficient de pondération est donc calculé à partir du seuil prédéterminé bas, du seuil prédéterminé haut et du paramètre lumineux (ici la luminosité).

L'unité de traitement 5 fait produire le signal audio secondaire Sas en utilisant le coefficient de pondération $\alpha$, les premières valeurs des paramètres audio et les deuxièmes valeurs des paramètres audio.

Le signal audio secondaire peut être produit dans ce cas selon la méthode illustrée à la figure 4.

Le signal d'entrée, c'est-à-dire le signal audio primaire, est dupliqué : étape E20.

Chaque copie est traitée indépendamment avec l'un des deux jeux de valeurs de paramètres.

Ainsi, les premières valeurs des paramètres audio sont appliquées sur une première copie Sap1 du signal pour obtenir un premier signal traité Sat1 : étape E21. Les deuxièmes valeurs des paramètres audio sont appliquées sur une deuxième copie Sap2 du signal pour obtenir un deuxième signal traité Sat2 : étape E22.

Ensuite les deux signaux traités Sat1, Sat2 sont combinés par une moyenne pondérée par le coefficient de pondération $\alpha$ : $So = (1-\alpha) \times Sat1 + \alpha \times Sat2$ : étape E23.

Il convient de noter que ce mode de réalisation peut être utilisé même dans le cas où les traitements réalisés à l'étape E21 et à l'étape E22 sont des traitements différents. En particulier, ce mode de réalisation peut être utilisé même si l'un des traitements réalisés à l'étape E21 et à l'étape E22 ne modifie pas le signal audio primaire, ce qui permet par exemple de réaliser une activation ou une désactivation douce d'un effet.

Ce mode de réalisation présente l'avantage d'être totalement générique : il peut s'appliquer à n'importe quelle paire de traitements E21, E22. En revanche ce mode de réalisation est relativement coûteux en calculs puisqu'il impose de traiter deux fois le signal audio primaire.

Selon un autre mode de réalisation, pour chaque paramètre audio, la première valeur de paramètre audio et la deuxième valeur de paramètre audio associées audit paramètre audio sont combinées indépendamment. On obtient de la sorte des valeurs de paramètres combinées, formant un profil audio qui est ensuite appliqué en une seule fois sur le signal audio primaire Sap.

Comme on l'a vu, les valeurs des paramètres de certains paramètres sont des valeurs numériques. Dans ce cas, ces valeurs de paramètres sont combinées par une moyenne pondérée, en utilisant le coefficient de pondération $\alpha$, pour obtenir des valeurs combinées de paramètres.

Cependant, certains paramètres sont des paramètres d'activation de filtre, c'est-à-dire des signaux booléens qui définissent si un filtre doit être appliqué ou non.

Par ailleurs, les filtres sont eux-mêmes généralement associés à des paramètres de filtrage (qui définissent non pas l'activation ou la désactivation du filtre, mais la réponse du filtre).

On définit donc un « jeu de paramètres », associé à un filtre (ou à un autre module fonctionnel individuel), comme étant un ensemble comprenant un paramètre d'activation et des paramètres de filtrage. On parle de « jeu de valeurs de paramètres » pour désigner les valeurs que peuvent prendre les paramètres du jeu de paramètres.

Les valeurs de paramètres combinées sont définies de la manière suivante.

Pour le paramètre d'activation, si les deux valeurs de paramètre (valeurs du signal booléen) ont la même valeur, alors la valeur de paramètre combinée est égale à cette même valeur.

Par contre, si les deux valeurs de paramètre ont des valeurs différentes, cela signifie que l'une des valeurs de paramètre est la valeur « vrai » (activation du filtre), et que l'autre des valeurs de paramètre est la valeur « faux » (filtre inactif).

Dans ce cas, la valeur de paramètre combinée prend la valeur « vrai ».

On a donc deux jeux de valeurs de paramètres associés au jeu de paramètres : un « jeu de valeurs actives » qui comprend la valeur de paramètre « vrai » pour le paramètre d'activation, et un « jeu de valeurs inactives » qui comprend la valeur de paramètre « faux » pour le paramètre d'activation.

Selon un premier mode de réalisation, les valeurs de paramètres des paramètres de filtrage sont combinées (en utilisant le coefficient de pondération $\alpha$) comme si le jeu de valeurs inactives comprenait des valeurs de paramètres minimales pour les paramètres de filtrage.

Par exemple, si le paramètre d'activation (signal booléen) contrôle l'activation d'un filtre de réverbération, la valeur de paramètre combinée pour le paramètre de niveau est calculée comme si le jeu de valeurs inactives comportait une valeur de -60 dB pour ce paramètre, et la valeur de paramètre combinée pour le paramètre de durée est calculée comme si le jeu de valeurs inactives comportait une valeur de zéro pour ce paramètre.

Alternativement, le filtre contrôlé par ledit paramètre d'activation (signal booléen) comporte un paramètre de filtrage affectant l'importance de son effet. Dans ce cas, la valeur de paramètre combinée pour ledit paramètre est calculée comme si le jeu de valeurs inactives comportait une valeur minimale pour le paramètre affectant l'importance de l'effet, et les valeurs de paramètres combinées pour les autres paramètres dudit filtre prennent une valeur égale à la valeur du jeu de valeurs actives.

Par exemple, si le paramètre d'activation (signal booléen) contrôle l'activation d'un filtre de réverbération, la valeur de paramètre combinée pour le paramètre de niveau est calculée comme si le jeu de valeurs inactives comportait une valeur de -60 dB pour ce paramètre, et la valeur de paramètre combinée pour le paramètre de durée est égale à la valeur du paramètre de durée dans le jeu de valeurs actives.

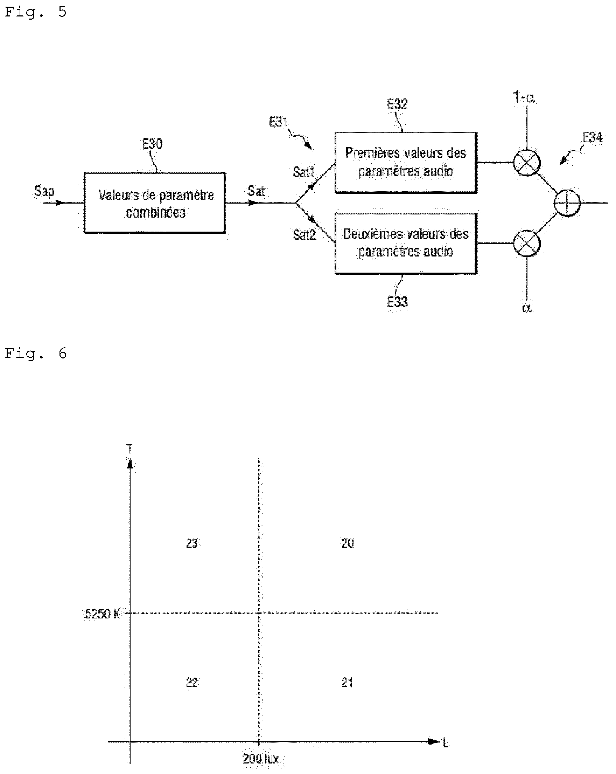

Selon un troisième mode de réalisation, dit mode hybride, certaines valeurs de paramètres sont combinées indépendamment afin d'obtenir un jeu de valeurs combinées partiel pouvant être appliqué en une seule fois, et d'autres valeurs de paramètres sont combinées par traitements indépendants. Par exemple en référence à la figure 5, les valeurs des paramètres d'égalisation peuvent être combinées pour être appliquées sur le signal audio primaire Sap en une seule fois : étape E30. Puis, le signal audio traité Sat est dupliqué pour former une première copie Sat1 et une deuxième copie Sat2 : étape E31.

Les premières valeurs de paramètres audio et les deuxièmes valeurs de paramètres audio sont alors appliquées indépendamment (étapes E32, E33) et combinées a posteriori : étape E34.

On a indiqué précédemment que le paramètre lumineux utilisé est la luminosité.

Cependant, le paramètre lumineux utilisé peut être différent. Le capteur photosensible 10 utilisé peut être un capteur de température de couleur, et le paramètre lumineux utilisé peut alors être la température de couleur de la lumière éclairant l'environnement du boîtier décodeur 1.

Il est connu que l'éclairage artificiel a généralement une température de couleur comprise entre 1800K et 6000K, tandis que l'éclairage naturel a généralement une température de couleur comprise entre 5500K et 8000K.

Par conséquent, les valeurs courantes des paramètres audio peuvent être sélectionnées comme cela a été présenté précédemment, mais en utilisant la température de couleur mesurée au lieu de la luminosité.

Ainsi, si la température de couleur mesurée est inférieure (ici inférieure ou égale) à un seuil prédéterminé, égal par exemple à 5750K, l'unité de traitement 5 sélectionne comme valeurs courantes des paramètres audio les premières valeurs des paramètres audio (profil nuit).

Si la température de couleur est supérieure (ici supérieure strictement) au seuil prédéterminé, l'unité de traitement 5 sélectionne comme valeurs courantes des paramètres audio les deuxièmes valeurs des paramètres audio (profil jour).

L'unité de traitement 5 fait alors appliquer par le module audio 9 les valeurs courantes des paramètres audio sur le signal audio primaire pour produire un signal audio secondaire, et fait restituer le signal audio secondaire via les haut-parleurs internes 8 ou les haut-parleurs externes 4.

Alternativement, la mesure de température de couleur peut être réalisée avec hystérésis.

L'unité de traitement 5 compare la température de couleur avec un seuil prédéterminé bas et avec un seuil prédéterminé haut.

Si la température de couleur est inférieure (ici inférieure strictement) au seuil prédéterminé bas, égal par exemple à 5500K, l'unité de traitement 5 sélectionne comme valeurs courantes des paramètres audio les premières valeurs des paramètres audio (profil nuit).

Si la température de couleur est supérieure (ici supérieure strictement) au seuil prédéterminé haut, égal par exemple à 6000K, l'unité de traitement 5 sélectionne comme valeurs courantes des paramètres audio les deuxièmes valeurs des paramètres audio (profil jour).

Si la température de couleur est comprise entre le seuil prédéterminé bas et le seuil prédéterminé haut, l'unité de traitement 5 continue de faire appliquer sur le signal audio primaire les valeurs courantes des paramètres audio préalablement sélectionnées, c'est-à-dire les premières valeurs des paramètres audio si celles-ci étaient utilisés, ou bien les deuxièmes valeurs des paramètres audio si celles-ci étaient utilisés.

Alternativement, si la température de couleur est comprise entre le seuil prédéterminé bas et le seuil prédéterminé haut, l'unité de traitement 5 combine deux jeux de paramètres en fonction d'un coefficient de pondération $\alpha$ compris entre 0 et 1, comme cela a été décrit plus tôt.

Le seuil prédéterminé bas $T^-$ est par exemple égal à 5500 K, et le seuil prédéterminé haut $T^+$ est par exemple égal à 6000K.

Selon un mode particulier de réalisation, l'unité de traitement 5 acquiert ou estime, en utilisant des mesures produites par un ou plusieurs capteurs photosensibles 10, un premier paramètre lumineux et un deuxième paramètre lumineux, en l'occurrence la luminosité et la température de couleur. L'unité de traitement 5 peut utiliser les mesures produites par un capteur de luminosité et par un capteur de température de couleur, si le boîtier décodeur 1 est équipé de ces deux capteurs. L'unité de traitement 5 peut aussi estimer les paramètres à partir des mesures produites par un seul capteur.

L'unité de traitement 5 compare alors la luminosité avec un premier seuil prédéterminé (par exemple égal à 200 lux), et la température de couleur avec un deuxième seuil prédéterminé (par exemple égal à 5750K).

Si la luminosité et la température de couleur sont inférieures (ici inférieures ou égales) respectivement au premier seuil prédéterminé et au deuxième seuil prédéterminé, l'unité de traitement 5 sélectionne et fait appliquer sur le signal audio primaire les premières valeurs des paramètres audio (profil nuit).

Si la luminosité et la température de couleur sont supérieures (ici strictement supérieures) respectivement au premier seuil prédéterminé et au deuxième seuil prédéterminé, l'unité de traitement 5 sélectionne et fait appliquer sur le signal audio primaire les deuxièmes valeurs des paramètres audio (profil jour).

Sinon, l'unité de traitement 5 continue à appliquer sur le signal audio primaire les valeurs courantes des paramètres audio préalablement sélectionnées.

On voit sur la figure 6 les différentes combinaisons possibles de luminosité mesurée et de température de couleur mesurée. L'axe des abscisses représente la luminosité mesurée, l'axe des ordonnées représente la température de couleur mesurée. Les deux seuils prédéterminés découpent le graphique en quatre secteurs 20, 21, 22, et 23. Lorsque la combinaison luminosité mesurée / température de couleur mesurée est dans le secteur 20, l'unité de traitement 5 fait appliquer les paramètres du profil « jour. » Lorsque la combinaison est dans le secteur 22, l'unité de traitement 5 fait appliquer les paramètres du profil « nuit. » Lorsque la combinaison est dans le secteur 21 ou 23, l'unité de traitement 5 conserve les paramètres en cours.

En variante, selon un mode de réalisation alternatif, lorsque la combinaison est dans le secteur 21 ou 23, l'unité de traitement 5 fait appliquer un jeu de paramètres prédéfini choisi en fonction du secteur. Optionnellement, ce jeu de paramètres a été défini par l'utilisateur à travers une interface de configuration.

Dans un mode de réalisation, le boîtier décodeur 1 ne comprend pas de capteur de luminosité mais comprend en revanche une caméra 30. Le capteur photosensible utilisé est intégré dans la caméra 30. Dans ce cas, l'unité de traitement 5 n'a pas forcément accès directement à des mesures de la luminosité.

Un module d'exposition automatique 31 est ici intégré dans la caméra 30.

L'unité de traitement 5 peut utiliser le module d'exposition automatique 31 pour estimer la luminosité.

Lorsque la caméra 30 capture une image, le module d'exposition automatique 31 choisit en effet les paramètres d'exposition (ouverture, temps de pose et sensibilité) de façon à optimiser le rendu de l'image capturée.

Ce choix ne nécessite pas nécessairement une étape explicite de mesure de la luminosité.

Cependant, les paramètres d'exposition sont liés à la luminosité ambiante par la formule suivante :

$$\frac{N^2}{t} = \frac{L \times S}{K}$$

où :

- N est l'ouverture du diaphragme,
- t est le temps de pose,
- L est la luminance de la scène,
- $S$ est la sensibilité du capteur,
- $K$ est une constante (généralement K = 12,5 cd/m$^2$).

L'unité de traitement 5 estime la luminosité à partir des paramètres d'exposition sélectionnés par le module d'exposition automatique 31, en utilisant la formule :

$$L = \frac{K \times N^2}{S \times t}$$

On note que de nombreuses webcams du marché ont une ouverture et une sensibilité fixées et ajustent l'exposition en modifiant uniquement le temps de pose. Avantageusement, dans ce cas, l'unité de traitement 5 peut comparer directement le temps de pose à un ou des seuils fixés plutôt que d'effectuer explicitement la conversion et de comparer la luminosité.

On note aussi que, dans ce cas, le sens des comparaisons est inversé : par exemple pour la méthode par simple mesure de luminosité, l'unité de traitement 5 fera appliquer le profil « nuit » (premières valeurs des paramètres audio) si le temps de pose est supérieur au seuil (ce qui correspond à une luminosité inférieure au seuil) et fera appliquer le profil « jour » (deuxièmes valeurs des paramètres audio) si le temps de pose est inférieur au seuil (ce qui correspond à une luminosité supérieure au seuil).

On note aussi que le module d'exposition automatique 31 peut être intégré dans la caméra 30 elle-même ou bien être un module du boîtier décodeur 1, relié à la caméra 30, qui contrôle les paramètres d'exposition de la caméra 30 pour optimiser le rendu de l'image. De même, si la caméra est connectée au boîtier décodeur 1 (et non intégrée dans celui-ci), le module d'exposition automatique peut être intégré dans la caméra ou relié à celle-ci.

De même, en ce qui concerne la température de couleur, le capteur photosensible 10 du boîtier décodeur 1 n'est pas nécessairement un capteur dédié à la mesure de ce paramètre lumineux.

A nouveau, le capteur photosensible 10 utilisé peut être intégré dans la caméra 30, et l'unité de traitement 5 n'a alors pas forcément accès directement à des mesures de la température de couleur.

Les modules d'exposition automatique de certaines caméras mesurent la température de couleur en même temps que l'illumination et peuvent donc être utilisés pour obtenir la température de couleur de l'éclairage ambiant, mais de nombreuses caméras ont un réglage de colorimétrie fixe.

La caméra 30 peut donc ne pas disposer pas d'un module d'exposition automatique 31 capable de mesurer la température de couleur. Dans ce cas, l'unité de traitement 5 acquiert une image produite par la caméra et estime la température de couleur à partir de ladite image.

Ici, l'unité de traitement 5 obtient une mesure de la température de couleur en suivant les étapes suivantes.

L'unité de traitement 5 acquiert une image produite par la caméra 30 au format RVB (Rouge Vert Bleu).

L'unité de traitement 5 calcule la couleur moyenne des pixels de l'image.

L'unité de traitement 5 estime alors la température de couleur à partir de la couleur moyenne des pixels de l'image, par exemple en utilisant le logiciel open source « color-temperature ».

L'unité de traitement 5 calcule le rapport

$$\rho = \bar{b}/\bar{r}$$ entre la moyenne des composantes bleues des pixels de l'image et la moyenne des composantes rouges des pixels de l'image.

L'unité de traitement 5 cherche alors par dichotomie la température de couleur qui correspond à une couleur ayant le même rapport entre sa composante rouge et sa composante bleue.

Avantageusement, l'unité de traitement 5 peut comparer directement le rapport $\rho$ à un ou des seuils fixés plutôt que d'effectuer explicitement la conversion et de comparer les températures de couleurs en Kelvin.

On note qu'il existe d'autres méthodes pour estimer la température de couleur à partir d'une image (voir par exemple le document « Estimating the Illuminant Color from the Shading of a Smooth Surface », Hsien-Che Lee, MIT A.I. Memo No. 1068 (1988)).

Il peut être pertinent de réaliser une phase de calibration, en opération, sur le capteur photosensible 10. En particulier, lorsque le capteur photosensible 10 utilisé est intégré dans une caméra 30, la mesure de luminosité ou de température de couleur peut être fortement affectée par la scène vue par la caméra.

Par exemple, la présence de rideaux ou de papier peint bleu pourra donner une température de couleur mesurée plus chaude que si les rideaux ou le papier peint était rouges dans les mêmes conditions d'éclairage. Il peut donc être intéressant de prévoir, au cours d'une phase de calibration, d'ajuster automatiquement les seuils prédéterminés aux conditions d'utilisation du boîtier décodeur 1.

À cet effet, l'unité de traitement 5 calcule une moyenne glissante sur plusieurs jours des luminosités et des températures de couleur mesurées et ajuste les seuils prédéterminés en fonction de ladite moyenne.

Par exemple, l'unité de traitement 5 calcule un seuil prédéterminé égal à la moyenne multipliée par un coefficient fixé (égal par exemple à 0,75). Ce mode de fonctionnement est particulièrement adapté pour la luminosité.

Par exemple, l'unité de traitement 5 calcule un seuil prédéterminé égal à la moyenne à laquelle est ajoutée (ou soustraite) une constante prédéterminée.

L'unité de traitement 5 peut calculer en outre un écart-type glissant sur plusieurs jours, et le seuil prédéterminé est alors égal à la moyenne à laquelle est ajouté (ou soustrait) l'écart-type multiplié par une constante prédéterminée. On a donc :

$$\tau = \mu + k \times \sigma$$

où $\tau$ désigne le seuil prédéterminé, $\mu$ désigne la moyenne, $\sigma$ désigne l'écart-type, et k désigne la constante prédéterminée (par exemple. $k$=-1,5).

On note que la mesure de température de couleur n'est pas fiable si la luminosité est trop faible. Avantageusement le calcul de moyenne et d'écart-type de la température de couleur ignore les mesures pour lesquelles la luminosité est inférieure à un seuil fixé (par exemple 10 lux) .

On sait qu'il est très difficile, voire impossible, de mesurer une température de couleur de façon fiable lorsque la luminosité est très faible. Selon un mode particulier de réalisation, et dans le cas où le boîtier décodeur 1 comprend un ou des capteurs photosensibles 10 capables de produire des mesures ou estimations de la luminosité et de la température de couleur, l'unité de traitement 5 compare la luminosité ambiante avec un seuil prédéterminé très bas (par exemple égal 10 lux) et applique le mode « nuit » si la luminosité ambiante est inférieure audit seuil bas. Si la luminosité mesurée est supérieure audit seuil bas, alors l'unité de traitement 5 choisit le profil en tenant compte au moins de la température de couleur.

Avantageusement, lorsque de nouvelles valeurs courantes des paramètres audio ont été sélectionnées pour remplacer de précédentes valeurs courantes des paramètres audio, l'unité de traitement 5 applique une transition douce afin d'éviter des artefacts audibles dans le signal sonore diffusé par le boîtier décodeur 1 (via les haut-parleurs 8 et 4).

Pour cela, l'unité de traitement 5 initialise un coefficient de combinaison β au début d'une période de transition de durée prédéterminée, puis fait varier progressivement le coefficient de combinaison β pendant la durée prédéterminée de la période de transition.

Au début de la période de transition, on a donc :

$$\beta = 0$$

A la fin de la période de transition, on a donc :

$$\beta = 1$$

Au cours de la période de transition, l'unité de traitement 5 produit le signal audio secondaire en utilisant le coefficient de combinaison β, les précédentes valeurs courantes des paramètres audio et les nouvelles valeurs courantes des paramètres audio. L'unité de traitement 5 applique des valeurs courantes des paramètres audio égales à des combinaisons entre les précédentes valeurs courantes des paramètres audio et les nouvelles valeurs courantes des paramètres audio. La méthode décrite plus tôt pour exploiter le paramètre de pondération peut être réutilisée avec le paramètre de combinaison.

L'unité de traitement 5 peut, lorsque de nouvelles valeurs courantes des paramètres audio ont été sélectionnées pour remplacer de précédentes valeurs courantes des paramètres audio, attendre la survenue d'une période de silence dans le signal audio primaire, et effectuer le remplacement au cours de ladite période de silence. Cela permet à nouveau éviter des artefacts audibles dans le signal sonore diffusé par le boîtier décodeur 1 (via les haut-parleurs 8 et 4).

Pour détecter une période de silence, l'unité de traitement 5 calcule par exemple une énergie moyenne du signal audio primaire (ou secondaire) et considère qu'il y a un silence si cette énergie est inférieure à un seuil prédéterminé (par exemple -40dB$_{FS}$) pendant une durée prédéterminée suffisamment longue (par exemple 500ms). Alternativement, l'unité de traitement 5 considère qu'il y a un silence si la valeur crête du signal audio primaire est inférieure au seuil pendant une durée prédéterminée suffisamment longue (possiblement égale à la durée prédéterminée ci-dessus).

L'unité de traitement 5 peut aussi, lorsque de nouvelles valeurs courantes des paramètres audio ont été sélectionnées pour remplacer de précédentes valeurs courantes des paramètres audio, attendre la réception d'un ordre de changement provenant d'un utilisateur et ayant pour but d'appliquer un changement sur le signal audio primaire. L'unité de traitement 5 effectue alors le remplacement en même temps que le changement est réalisé.

L'ordre de changement est par exemple un ordre de changement de source (« *zapping* »), ou une mise en pause ou redémarrage de la lecture.

Selon un mode de réalisation particulier, le boîtier décodeur 1 reçoit des métadonnées dans le flux audio-vidéo Fav, qui identifient le programme en cours de diffusion (par exemple les EIT, pour « *Event Information Tables* » de la norme DVB). Le programme en cours de diffusion inclut le signal audio primaire en cours de restitution.

L'unité de traitement 5 acquiert ces métadonnées.

Lorsque de nouvelles valeurs courantes des paramètres audio ont été sélectionnées pour remplacer de précédentes valeurs courantes des paramètres audio, l'unité de traitement 5 attend que les métadonnées indiquent un changement de programme en cours de diffusion (et donc du signal audio primaire), puis effectue le remplacement en même temps que le changement est réalisé.

Bien entendu, l'invention n'est pas limitée aux modes de réalisation décrits mais englobe toute variante entrant dans le champ de l'invention telle que définie par les revendications.

On a décrit ici l'utilisation possible de deux profils « jour » et « nuit », et de deux plages de fonctionnement définies par des seuils prédéterminés et correspondant aux deux profils.

L'invention peut aussi s'appliquer à un nombre de profils plus important avec les plages de fonctionnement correspondantes, par exemple il pourrait y avoir trois profils « jour », « nuit » et « intermédiaire » avec trois plages de fonctionnement correspondant à une luminosité très faible, une luminosité moyenne et une luminosité élevée.

L'équipement électrique dans lequel est mise en œuvre l'invention n'est pas nécessairement un boîtier décodeur, mais peut être tout équipement électrique capable de restituer des signaux audio : enceinte connectée, ordinateur, *smartphone,* console de jeux, etc.

## Revendications

1. Equipement de restitution audio (1), comprenant :

   - au moins un haut-parleur interne (8), et/ou des moyens de connexion avec au moins un haut-parleur externe (4) ;
   - au moins un capteur photosensible interne (10) qui est intégré dans une caméra (30) intégrée dans l'équipement de restitution audio, et/ou des moyens de connexion avec au moins un capteur photosensible externe qui est intégré dans une caméra connectée à l'équipement de restitution audio ;
   - une unité de traitement (5) agencée pour :

     o acquérir ou estimer, en utilisant au moins une mesure produite par le capteur photosensible interne et/ou le capteur photosensible externe, au moins un paramètre lumineux représentatif d'une lumière éclairant un environnement de l'équipement de restitution audio (1), le au moins un paramètre lumineux comprenant au moins un paramètre parmi une luminosité et une température de couleur ;

     o sélectionner, en fonction du paramètre lumineux, des valeurs courantes de paramètres audio ;
     o faire appliquer les valeurs courantes des paramètres audio sur un signal audio primaire (Sap) pour produire un signal audio secondaire (Sas) ;
     o faire restituer le signal audio secondaire via le haut-parleur interne (8) et/ou le haut-parleur externe (4).

2. Equipement de restitution audio selon la revendication 1, dans lequel les valeurs courantes des paramètres audio sont sélectionnées parmi des premières valeurs des paramètres audio et des deuxièmes valeurs des paramètres audio, l'unité de traitement (5) étant agencée pour comparer le paramètre lumineux avec au moins un seuil prédéterminé, et pour sélectionner les premières valeurs des paramètres audio ou les deuxièmes valeurs des paramètres audio en fonction de ladite comparaison.

3. Equipement de restitution audio selon la revendication 2, l'unité de traitement (5) étant agencée pour

   - comparer le paramètre lumineux avec un seuil prédéterminé bas et avec un seuil prédéterminé haut ;
   - si ledit paramètre lumineux est inférieur au seuil prédéterminé bas, sélectionner et appliquer sur le signal audio primaire les premières valeurs des paramètres audio ;
   - si ledit paramètre lumineux est supérieur au seuil prédéterminé haut, sélectionner et appliquer sur le signal audio primaire les deuxièmes valeurs des paramètres audio.

4. Equipement de restitution audio selon la revendication 3, dans lequel l'unité de traitement (5) est agencée pour, si ledit paramètre lumineux est compris entre le seuil prédéterminé bas et le seuil prédéterminé haut, continuer à faire appliquer sur le signal audio primaire les valeurs courantes des paramètres audio préalablement sélectionnées.

5. Equipement de restitution audio selon la revendication 3, dans lequel l'unité de traitement (5) est agencée pour, si ledit paramètre lumineux est compris entre le seuil prédéterminé bas et le seuil prédéterminé haut, faire produire le signal audio secondaire en utilisant un coefficient de pondération, les premières valeurs des paramètres audio et les deuxièmes valeurs des paramètres audio, le coefficient de pondération étant calculé à partir du seuil prédéterminé bas, du seuil prédéterminé haut et dudit paramètre lumineux.

6. Equipement de restitution audio selon la revendication 1, l'unité de traitement (5) étant agencée pour acquérir ou estimer un premier paramètre lumineux, ledit premier paramètre lumineux étant la luminosité, et un deuxième paramètre lumineux, ledit deuxième paramètre lumineux étant la température de couleur, les valeurs courantes des paramètres audio étant sélectionnées parmi des premières valeurs des paramètres audio et des deuxièmes valeurs des paramètres audio,

l'unité de traitement (5) étant en outre agencée pour :

- comparer le premier paramètre lumineux avec un premier seuil prédéterminé, et le deuxième paramètre lumineux avec un deuxième seuil prédéterminé ;
- si le premier paramètre lumineux et le deuxième paramètre lumineux sont inférieurs respectivement au premier seuil prédéterminé et au deuxième seuil prédéterminé, sélectionner et faire appliquer sur le signal audio primaire les premières valeurs des paramètres audio ;
- si le premier paramètre lumineux et le deuxième paramètre lumineux sont supérieurs respectivement au premier seuil prédéterminé et au deuxième seuil prédéterminé, sélectionner et faire appliquer sur le signal audio primaire les deuxièmes valeurs des paramètres audio.

7. Equipement de restitution audio selon l'une des revendications précédentes, un module d'exposition automatique (31) étant intégré dans ou relié à ladite caméra, le au moins un paramètre lumineux comprenant une luminosité, l'unité de traitement (5) étant agencée pour estimer la luminosité à partir de paramètres d'exposition sélectionnés par le module d'exposition automatique.

8. Equipement de restitution audio selon l'une des revendications précédentes, le au moins un paramètre lumineux comprenant une température de couleur, l'unité de traitement (5) étant agencée pour :

- acquérir une image produite par la caméra (30) ;
- estimer la température de couleur à partir de ladite image.

9. Equipement de restitution audio selon la revendication 8, comprenant l'étape de calculer une couleur moyenne de pixels de l'image, et d'estimer la température de couleur à partir de la couleur moyenne.

10. Equipement de restitution audio selon l'une des revendications précédentes, l'unité de traitement (5) étant agencée pour, lorsque de nouvelles valeurs courantes des paramètres audio ont été sélectionnées pour remplacer de précédentes valeurs courantes des paramètres audio :

- initialiser un coefficient de combinaison au début d'une période de transition de durée prédéterminée, et faire varier progressivement le coefficient de combinaison pendant la période de transition ;
- au cours de la période de transition, produire le signal audio secondaire (Sas) en utilisant le coefficient de combinaison, les précédentes valeurs courantes des paramètres audio et les nouvelles valeurs courantes des paramètres audio ;
- suite à la période de transition, produire le signal audio secondaire (Sas) en utilisant les nouvelles valeurs courantes des paramètres audio.

11. Equipement de restitution audio selon l'une des revendications 1 à 9, l'unité de traitement (5) étant agencée pour, lorsque de nouvelles valeurs courantes des paramètres audio ont été sélectionnées pour remplacer de précédentes valeurs courantes des paramètres audio, attendre la survenue d'une période de silence dans le signal audio primaire, et effectuer le remplacement au cours de ladite période de silence.

12. Equipement de restitution audio selon l'une des revendications 1 à 9, l'unité de traitement (5) étant agencée pour, lorsque de nouvelles valeurs courantes des paramètres audio ont été sélectionnées pour remplacer de précédentes valeurs courantes des paramètres audio, attendre une réception d'un ordre de changement provenant d'un utilisateur et ayant pour but d'appliquer un changement sur le signal audio primaire, puis effectuer le remplacement en même temps que le changement est réalisé.

13. Equipement de restitution audio selon l'une des revendications 1 à 9, l'unité de traitement (5) étant agencée pour recevoir des métadonnées identifiant un programme en cours de diffusion incluant le signal audio primaire, et, lorsque de nouvelles valeurs courantes des paramètres audio ont été sélectionnées pour remplacer de précédentes valeurs courantes des paramètres audio, attendre que les métadonnées indiquent un changement du programme en cours de diffusion, puis effectuer le remplacement en même temps que le changement est réalisé.

14. Equipement de restitution audio selon l'une des revendications précédentes, dans lequel les paramètres audio comprennent :

- des paramètres d'égalisation, comprenant des gains ou des listes de gains pour différentes bandes de fréquences, et/ou
- des paramètres d'activation d'un ou de plusieurs filtres, et/ou
- des paramètres de filtrage définissant, pour chaque filtre, une réponse dudit filtre.

15. Equipement de restitution audio selon la revendication 14, dans lequel le ou les filtres comprennent un filtre correcteur physiologique et/ou un filtre compresseur et/ou un filtre d'amélioration de l'intelligibilité de la voix et/ou un filtre de réverbération et/ou un filtre atténuateur de bruit de fond.

16. Equipement de restitution audio selon l'une des revendications précédentes, l'équipement de restitution audio étant un boîtier décodeur (1).

17. Procédé de restitution audio, mis en œuvre dans l'unité de traitement (5) d'un équipement de restitution audio selon l'une des revendications précédentes, et comprenant les étapes de :

- acquérir ou estimer, en utilisant au moins une mesure produite par le capteur photosensible interne et/ou le capteur photosensible externe, au moins un paramètre lumineux représentatif d'une lumière éclairant un environnement de l'équipement de restitution audio (1), le au moins un paramètre lumineux comprenant au moins un paramètre parmi une luminosité et une température de couleur;
- sélectionner, en fonction du paramètre lumineux, des valeurs courantes de paramètres audio ;
- faire appliquer les valeurs courantes des paramètres audio sur un signal audio primaire (Sap) pour produire un signal audio secondaire (Sas) ;
- faire restituer le signal audio secondaire via le haut-parleur interne (8) et/ou le haut-parleur externe (4).

18. Programme d'ordinateur comprenant des instructions qui conduisent l'unité de traitement de l'équipement de restitution audio selon l'une des revendications 1 à 16 à exécuter les étapes du procédé de restitution audio selon la revendication 17 lorsque ledit programme est exécuté par un ordinateur.

19. Support d'enregistrement lisible par ordinateur, sur lequel est enregistré le programme d'ordinateur selon la revendication 18.

**Patentansprüche**

1. Audiowiedergabegerät (1), umfassend:

- zumindest einen internen Lautsprecher (8) und/oder Anschlussmittel zum Verbinden mit zumindest einem externen Lautsprecher (4);

- zumindest einen internen Fotosensor (10), der in einer in dem Audiowiedergabegerät integrierten Kamera (30) eingebaut ist, und/oder Anschlussmittel zum Verbinden mit zumindest einem externen Fotosensor, der in einer an das Audiowiedergabegerät angeschlossenen Kamera eingebaut ist;
- eine Verarbeitungseinheit (5), die dafür ausgelegt ist:

o unter Verwendung zumindest eines von dem internen Fotosensor und/oder von dem externen Fotosensor erzeugten Messwerts zumindest einen Lichtparameter, der ein eine Umgebung des Audiowiedergabegeräts (1) beleuchtendes Licht darstellt, zu erfassen oder zu schätzen, wobei der zumindest eine Lichtparameter zumindest einen Parameter bestehend aus einer Helligkeit und einer Farbtemperatur umfasst;
o in Abhängigkeit von dem Lichtparameter aktuelle Werte von Audioparametern auszuwählen;
o die Anwendung der aktuellen Werte der Audioparameter auf ein primäres Audiosignal (Sap) zu veranlassen, um ein sekundäres Audiosignal (SAS) zu erzeugen;
o die Wiedergabe des sekundären Audiosignals über den internen Lautsprecher (8) und/oder den externen Lautsprecher (4) zu veranlassen.

2. Audiowiedergabegerät nach Anspruch 1, wobei die aktuellen Werte der Audioparameter aus ersten Werten der Audioparameter und aus zweiten Werten der Audioparameter ausgewählt werden, wobei die Verarbeitungseinheit (5) dafür ausgelegt ist, den Lichtparameter mit zumindest einem vorbestimmten Schwellenwert zu vergleichen und die ersten Werte der Audioparameter oder die zweiten Werte der Audioparameter in Abhängigkeit von besagtem Vergleich auszuwählen.

3. Audiowiedergabegerät nach Anspruch 2, wobei die Verarbeitungseinheit (5) dafür ausgelegt ist:

- den Lichtparameter mit einem vorbestimmten niedrigen Schwellenwert und mit einem vorbestimmten hohen Schwellenwert zu vergleichen;
- wenn der Lichtparameter unterhalb des vorbestimmten niedrigen Schwellenwerts liegt, die ersten Werte der Audioparameter auszuwählen und auf das primäre Audiosignal anzuwenden;
- wenn der Lichtparameter oberhalb des vorbestimmten hohen Schwellenwerts liegt, die zweiten Werte der Audioparameter auszuwählen und auf das primäre Audiosignal anzuwenden;

4. Audiowiedergabegerät nach Anspruch 3, wobei die Verarbeitungseinheit (5) dafür ausgelegt ist, wenn der Lichtparameter zwischen dem vorbestimmten niedrigen Schwellenwert und dem vorbestimmten hohen Schwellenwert liegt, die Anwendung der aktuellen Werte der zuvor ausgewählten Audioparameter auf das primäre Audiosignal weiterhin fortbestehen zu lassen.

5. Audiowiedergabegerät nach Anspruch 3, wobei die Verarbeitungseinheit (5) dafür ausgelegt ist, wenn der Lichtparameter zwischen dem vorbestimmten niedrigen Schwellenwert und dem vorbestimmten hohen Schwellenwert liegt, die Erzeugung des sekundären Audiosignals unter Verwendung eines Gewichtungskoeffizienten, der ersten Werte der Audioparameter und der zweiten Werte der Audioparameter zu veranlassen, wobei der Gewichtungskoeffizient aus dem vorbestimmten niedrigen Schwellenwert, dem vorbestimmten hohen Schwellenwert und dem Lichtparameter errechnet wird.

6. Audiowiedergabegerät nach Anspruch 1, wobei die Verarbeitungseinheit (5) dafür ausgelegt ist, einen ersten Lichtparameter und einen zweiten Lichtparameter zu erfassen oder zu schätzen, wobei es sich bei dem ersten Lichtparameter um die Helligkeit und bei dem zweiten Lichtparameter um die Farbtemperatur handelt, wobei die aktuellen Werte der Audioparameter aus den ersten Werten der Audioparameter und aus den zweiten Werten der Audioparameter ausgewählt sind, wobei die Verarbeitungseinheit (5) ferner dafür ausgelegt ist,

    - den ersten Lichtparameter mit einem ersten vorbestimmten Schwellenwert und den zweiten Lichtparameter mit einem zweiten vorbestimmten Wert zu vergleichen;
    - wenn der erste Lichtparameter und der zweite Lichtparameter jeweils unterhalb des ersten vorbestimmten Schwellenwerts bzw. des zweiten vorbestimmten Schwellenwerts liegen, die ersten Werte der Audioparameter auszuwählen und deren Anwendung auf das primäre Audiosignal zu veranlassen;
    - wenn der erste Lichtparameter und der zweite Lichtparameter jeweils oberhalb des ersten vorbestimmten Schwellenwerts bzw. des zweiten vorbestimmten Schwellenwerts liegen, die zweiten Werte der Audioparameter auszuwählen und deren Anwendung auf das primäre Audiosignal zu veranlassen.

7. Audiowiedergabegerät nach einem der vorhergehenden Ansprüche, wobei ein automatisches Belichtungsmodul (31) in der Kamera integriert ist oder mit dieser verbunden ist, wobei der zumindest eine Lichtparameter eine Helligkeit umfasst, wobei die Verarbeitungseinheit (5) dafür ausgelegt ist, aus von dem automatischen Belichtungsmodul ausgewählten Belichtungsparametern die Helligkeit zu schätzen.

8. Audiowiedergabegerät nach einem der vorhergehenden Ansprüche, wobei der zumindest eine Lichtparameter eine Farbtemperatur umfasst, wobei die Verarbeitungseinheit (5) dafür ausgelegt ist:

    - ein von der Kamera (30) erzeugtes Bild zu erfassen;
    - aus diesem Bild die Farbtemperatur zu schätzen.

9. Audiowiedergabegerät nach Anspruch 8, umfassend den Schritt, in dem eine mittlere Pixelfarbe des Bildes errechnet wird und aus der mittleren Farbe die Farbtemperatur geschätzt wird.

10. Audiowiedergabegerät nach einem der vorhergehenden Ansprüche, wobei die Verarbeitungseinheit (5) dafür ausgelegt ist, wenn neue aktuelle Werte der Audioparameter ausgewählt worden sind, welche die vorherigen aktuellen Werte der Audioparameter ersetzen:

    - zu Beginn einer Übergangsperiode von vorbestimmter Dauer einen Kombinationskoeffizienten zu initialisieren und während der Übergangsperiode eine schrittweise Veränderung des Kombinationskoeffizienten zu veranlassen;
    - während der Übergangsperiode unter Verwendung des Kombinationskoeffizienten, der vorherigen aktuellen Werte der Audioparameter und der neuen aktuellen Werte der Audioparameter das sekundäre Audiosignal (SAS) zu erzeugen;
    - im Anschluss an die Übergangsperiode unter Verwendung der neuen aktuellen Werte der Audioparameter das sekundäre Audiosignal (SAS) zu erzeugen.

11. Audiowiedergabegerät nach einem der Ansprüche 1 bis 9, wobei die Verarbeitungseinheit (5) dafür ausgelegt ist, wenn neue aktuelle Werte der Audioparameter ausgewählt worden sind, welche die vorherigen aktuellen Werte der Audioparameter ersetzen, auf das Eintreten einer Stilleperiode in dem primären Audiosignal zu warten und die Ersetzung während dieser Stilleperiode durchzuführen.

12. Audiowiedergabegerät nach einem der Ansprüche 1 bis 9, wobei die Verarbeitungseinheit (5) dafür ausgelegt ist, wenn neue aktuelle Werte der Audioparameter ausgewählt worden sind, welche die vorherigen aktuellen Werte der Audioparameter ersetzen, auf einen Empfang eines Änderungsbefehls seitens eines Benutzers zu warten, welcher darauf abzielt, eine Änderung auf das primäre Audiosignal anzuwenden, und anschließend die Ersetzung zeitgleich mit der Änderung durchzuführen.

13. Audiowiedergabegerät nach einem der Ansprüche 1 bis 9, wobei die Verarbeitungseinheit (5) dafür ausgelegt ist, Metadaten zu empfangen, die ein das primäre Audiosignal enthaltendes, gerade laufendes Programm kennzeichnen, und, wenn neue aktuelle Werte der Audioparameter ausgewählt worden sind, welche die vorherigen aktuellen Werte der Audioparameter ersetzen, darauf zu warten, dass die Metadaten eine Änderung des gerade laufenden Programms anzeigen, und anschließend die Ersetzung zeitgleich mit der Änderung durchzuführen.

14. Audiowiedergabegerät nach einem der vorhergehenden Ansprüche, wobei die Audioparameter umfassen:

- Ausgleichsparameter, die Verstärkungen oder Listen von Verstärkungen für verschiedene Frequenzbänder umfassen, und/oder
- Aktivierungsparameter eines oder mehrerer Filter, und/oder
- Filterparameter, die für jeden Filter eine Filterantwort definieren.

15. Audiowiedergabegerät nach Anspruch 14, wobei der eine oder die mehreren Filter einen physiologischen Korrekturfilter und/oder einen Kompressionsfilter und/oder einen Filter zur Verbesserung der Sprachverständlichkeit und/oder einen Nachhallfilter und/oder einen Filter zur Dämpfung von Grundgeräuschen umfassen.

16. Audiowiedergabegerät nach einem der vorhergehenden Ansprüche, wobei es sich bei dem Audiowiedergabegerät um eine Decoderbox (1) handelt.

17. Verfahren zur Audio-Wiedergabe, welches in der Verarbeitungseinheit (5) eines Audiowiedergabegeräts nach einem der vorhergehenden Ansprüche ausgeführt wird und die Schritte umfasst, dass:

- unter Verwendung zumindest eines von dem internen Fotosensor und/oder von dem externen Fotosensor erzeugten Messwerts zumindest ein Lichtparameter, der ein eine Umgebung des Audiowiedergabegeräts (1) beleuchtendes Licht darstellt, erfasst oder geschätzt wird, wobei der zumindest eine Lichtparameter zumindest einen Parameter bestehend aus einer Helligkeit und einer Farbtemperatur umfasst;
- in Abhängigkeit von dem Lichtparameter aktuelle Werte von Audioparametern ausgewählt werden;

- die Anwendung der aktuellen Werte der Audioparameter auf ein primäres Audiosignal (Sap) veranlasst wird, um ein sekundäres Audiosignal (Sas) zu erzeugen;
- die Wiedergabe des sekundären Audiosignals über den internen Lautsprecher (8) und/oder den externen Lautsprecher (4) veranlasst wird.

18. Computerprogramm, das Befehle umfasst, welche die Verarbeitungseinheit des Audiowiedergabegeräts nach einem der Ansprüche 1 bis 16 dazu veranlassen, die Schritte des Verfahren zur Audio-Wiedergabe nach Anspruch 17 auszuführen, wenn das Programm von einem Computer ausgeführt wird.

19. Computerlesbares Speichermedium, auf welchem das Computerprogramm nach Anspruch 18 abgespeichert ist.

**Claims**

1. Audio playback equipment (1), comprising:

- at least one internal loudspeaker (8), and/or means for connecting with at least one external loudspeaker (4);
- at least one internal photosensitive sensor (10) which is integrated in a camera (30) integrated in the audio playback equipment, and/or means for connecting with at least one external photosensitive sensor, which is integrated in a camera connected to the audio playback equipment;
- a processing unit (5) arranged to:

∘ acquire or estimate, by using at least one measurement produced by the internal photosensitive sensor and/or the external photosensitive sensor, at least one light parameter representative of a light illuminating an environment of the audio playback equipment (1), the at least one light parameter comprising at least one parameter from a luminosity and a colour temperature;
∘ select, according to the light parameter, current values of audio parameters;
∘ apply the current values of the audio parameters on a primary audio signal (Sap) to produce a secondary audio signal (Sas);
∘ playback the secondary audio signal via the internal loudspeaker (8) and/or the external loudspeaker (4).

2. Audio playback equipment according to claim 1, wherein the current values of the audio parameters are selected from among first values of the audio parameters and second values of the audio parameters, the processing unit (5) being arranged to compare the light parameter with at least one predetermined threshold, and to select the first values of the audio parameters or the second values of the audio parameters according to said comparison.

3. Audio playback equipment according to claim 2, the processing unit (5) being arranged to

   - compare the light parameter with a predetermined low threshold and with a predetermined high threshold;
   - if said light parameter is less than the predetermined low threshold, select and apply on the primary audio signal, the first values of the audio parameters;
   - if said light parameter is greater than the predetermined high threshold, select and apply on the primary audio signal, the second values of the audio parameters.

4. Audio playback equipment according to claim 3, wherein the processing unit (5) is arranged to, if said light parameter is comprised between the predetermined low threshold and the predetermined high threshold, continue to apply on the primary audio signal, the current values of the audio parameters previously selected.

5. Audio playback equipment according to claim 3, wherein the processing unit (5) is arranged to, if said light parameter is comprised between the predetermined low threshold and the predetermined high threshold, produce the secondary audio signal by using a weighting coefficient, the first values of the audio parameters and the second values of the audio parameters, the weighting coefficient being calculated from the predetermined low threshold, from the predetermined high threshold and from said light parameter.

6. Audio playback equipment according to claim 1, the processing unit (5) being arranged to acquire or estimate a first light parameter, said first light parameter being the luminosity , and a second light parameter, said second light parameter being the colour temperature, the current values of the audio parameters being selected from among the first values of the audio parameters and the second values of the audio parameters, the processing unit (5) being further arranged to:

   - compare the first light parameter with a first predetermined threshold, and the second light parameter with a second predetermined threshold;
   - if the first light parameter and the second light parameter are respectively less than the first predetermined threshold and than the second determined threshold, select and apply on the primary audio signal, the first values of the audio parameters;
   - if the first light parameter and the second light parameter are respectively greater than the first predetermined threshold and than the second predetermined threshold, select and apply on the primary audio signal, the second values of the audio parameters.

7. Audio playback equipment according to any one of the preceding claims, an automatic exposure module (31) being integrated in or connected to said camera, the at least one light parameter comprising a luminosity, the processing unit (5) being arranged to estimate the luminosity from exposure parameters selected by the automatic exposure module.

8. Audio playback equipment according to any one of the preceding claims, the at least one light parameter comprising a colour temperature, the processing unit (5) being arranged to:

   - acquire an image produced by the camera (30);
   - estimate the colour temperature from said image.

9. Audio playback equipment according to claim 8, comprising the step of calculating an average colour of pixels of the image, and of estimating the colour temperature from the average colour.

10. Audio playback equipment according to any one of the preceding claims, the processing unit (5) being arranged to, when new current values of the audio parameters have been selected to replace previous current values of the audio parameters:

    - initialise a combination coefficient at the start of a transition period of predetermined duration, and progressively vary the combination coefficient during the transition period;
    - during the transition period, produce the secondary audio signal (Sas) by using the combination coefficient, the previous current values of the audio parameters and the new current values of the audio parameters;
    - following the transition period, produce the secondary audio signal (Sas) by using the new current values of the audio parameters.

11. Audio playback equipment according to any one of claims 1 to 9, the processing unit (5) being arranged to, when new current values of the audio parameters have been selected to replace previous current values of the audio parameters, expect the occurrence of a period of silence in the primary audio signal, and make the replacement during said period of silence.

12. Audio playback equipment according to any one of claims 1 to 9, the processing unit (5) being arranged to, when new current values of the audio parameters have been selected to replace previous current values of the audio parameters, expect a reception of a change order coming from a user and aiming to apply a change on the primary audio signal, then make the replacement at the same time as the change is made.

13. Audio playback equipment according to any one of claims 1 to 9, the processing unit (5) being arranged to receive metadata identifying a programme being broadcast including the primary audio signal, and, when new current values of the audio parameters have been selected to replace previous current values of the audio parameters, expect that the metadata indicate a change of the programme being broadcast, then make the replacement at the same time as the change is made.

14. Audio playback equipment according to any one of the preceding claims, wherein the audio parameters comprise:

   - equalisation parameters, comprising gains or lists of gains for different frequency bands, and/or
   - activation parameters of one or more filters, and/or
   - filtering parameters defining, for each filter, a response from said filter.

15. Audio playback equipment according to claim 14, wherein the filter(s) comprise(s) a physiological corrective filter and/or a compressor filter and/or a voice intelligibility improvement filter and/or a reverberation filter and/or a background noise damper filter.

16. Audio playback equipment according to any one of the preceding claims, the audio playback equipment being a set-top box (1).

17. Audio playback method, implemented in the processing unit (5) of a piece of audio playback equipment according to any one of the preceding claims, and comprising the steps of:

   - acquire or estimate, by using at least one measurement produced by the internal photosensitive sensor and/or the external photosensitive sensor, at least one light parameter representative of a light illuminating an environment of the audio playback equipment (1), said at least one light parameter comprising at least one parameter from a luminosity and a colour temperature;
   - select, according to the light parameter, current values of audio parameters;
   - apply the current values of audio parameters on a primary audio signal (Sap) to produce a secondary audio signal (Sas);
   - playback the secondary audio signal via the internal loudspeaker (8) and/or the external loudspeaker (4).

18. Computer program comprising instructions which lead to the processing unit of the audio playback equipment according to one of claims 1 to 18 executing the steps of the audio playback method according to claim 17 when said program is executed by a computer.

19. Recording medium which can be read by a computer, on which the computer program according to claim 18 is recorded.

Fig. 1

Fig. 2

Fig. 3

```
                              ●
                              |
                    ┌──────────────────┐
                    │  Acquisition des │──── E10
                    │     mesures      │
                    └──────────────────┘
                              |
                                   E11
                         ◇◇◇◇◇◇◇◇◇◇◇
              ┌──────────◇ Comparaison ◇──────────┐
              │          ◇   avec Sb   ◇          │
              │          ◇◇◇◇◇◇◇◇◇◇◇          │
    ┌──────────────┐                                │
E12 │  Profil nuit │                         E13    │
    └──────────────┘                    ◇◇◇◇◇◇◇◇◇◇◇
                         ┌──────────◇ Comparaison ◇──────────┐
                         │          ◇   avec Sh   ◇          │
                         │          ◇◇◇◇◇◇◇◇◇◇◇          │
                 ┌──────────────┐              ┌──────────────┐
             E15 │  Même profil │              │  Profil jour │──── E14
                 └──────────────┘              └──────────────┘
```

Fig. 4

```
                              E21              1-α
                    ┌──────────────────┐
       E20          │ Premières valeurs des │  Sat1    ⊗        E23
         ↘          │  paramètres audio     │──────────         ↙
             Sap1   └──────────────────┘            \
 Sap ──────┤                                          ⊕ ──────
             Sap2   ┌──────────────────┐            /
                    │ Deuxièmes valeurs des │  Sat2    ⊗
                    │  paramètres audio     │──────────
                    └──────────────────┘
                              E22               α
```

Fig. 5

E30

Sap →

Valeurs de paramètre
combinées

→ Sat

E31

Sat1

E32

Premières valeurs des
paramètres audio

1-α

⊗

E34

⊕

Sat2

Deuxièmes valeurs des
paramètres audio

⊗

E33

α

Fig. 6

T

23

20

5250 K

22

21

L

200 lux

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2016162255 A1

- US 2016057555 A1

**Littérature non-brevet citée dans la description**

- **HSIEN-CHE LEE**. Estimating the Illuminant Color from the Shading of a Smooth Surface. *MITA.I. Memo No. 1068*, 1988